(19) Europäisches Patentamt
European Patent Office
Office européen des brevets

(11) **EP 1 873 697 A1**

(12) **EUROPEAN PATENT APPLICATION**
published in accordance with Art. 153(4) EPC

(43) Date of publication:
**02.01.2008 Bulletin 2008/01**

(51) Int Cl.:
***G06N 3/00*** (2006.01)    ***G06F 17/50*** (2006.01)

(21) Application number: **06731001.1**

(22) Date of filing: **03.04.2006**

(86) International application number:
**PCT/JP2006/307053**

(87) International publication number:
**WO 2006/107025 (12.10.2006 Gazette 2006/41)**

(84) Designated Contracting States:
**BE DE FR GB IT NL**

(30) Priority: **04.04.2005 JP 2005108065**

(71) Applicant: **Evolvable Systems Research Institute, Inc.**
**Tokyo 105-0013 (JP)**

(72) Inventors:
• **MURAKAWA, Masahiro**
  **c/o Evolvable Systems Research Institute Inc.**
  **Tokyo 1050013 (JP)**

• **ITO, Keiichi**
  **c/o Evolvable Systems Research Institute, Inc.**
  **Tokyo 1050013 (JP)**
• **BABA, Shunsuke**
  **Semiconductor Leading Edge Technologies Inc.**
  **Ibaraki 3058569 (JP)**

(74) Representative: **Gassner, Wolfgang et al**
  **Dr. Gassner & Partner**
  **Marie-Curie-Straße 1**
  **D-91052 Erlangen (DE)**

(54) **PARAMETER ADJUSTER**

(57)     Efficient and high-accuracy parameter adjustment is performed by applying a genetic algorithm to a parameter adjustment such as a physical model of a transistor and so on. A parameter adjusting device includes a device generating new parameter genes by an initial population generating device and a special crossover processing by a Latin hyper square method. Also, a normalization device is provided for applying to parameters which are real numbers. Moreover, for example, to exactly meet a specific property of the transistor (MOSFET), an evaluation device which evaluates a parameter in consideration of a log scale, is provided. According to the above-mentioned structure, the genetic algorithm can be applied to the parameter adjustment with a large number of parameters such as the physical model of the transistor and so on, so that a parameter group can be determined with a high degree of accuracy within a short time.

**Fig. 3**

Fitting processing (S12)

S20 Preparing discrete (measured) data group

S21 Generating N chromosomes as initial population

S22 Selection, crossover processing

S23 Calculating evaluation values

S24 Eliminating individuals with low evaluation values

S25 Satisfying switching condition? — N / Y

S26 Fitting processing by the Powell method

End

**Description**

TECHNICAL FIELD OF THE INVENTION

The present invention relates to a parameter adjusting device, especially, a parameter adjusting device that can adjust a large number of parameters in a model with a large number of parameters such as a physical model of a semiconductor element such as a transistor and the like, within a short time.

BACKGROUND OF THE ART

For example, in the case of LSI manufacturing, first, samples of several transistors (MOSFET) with a different shape of a channel length L, a channel width W, and so on of a gate of the transistor (MOSFET) are tested in the manufacturing line. Next, from the measurement result of an electric property of a tested piece, a plurality of parameters of the physical model of the transistor are adjusted so as to conform with the transistor property which is manufactured in the relevant manufacturing line with a high degree of accuracy. Simulation of various types of LSI (transistor) which are manufactured in the relevant manufacturing line by the heretofore known circuit simulator such as SPICE was carried out by using the physical model of the transistor.

The physical model of the transistor represents relationships such as Vg (gate voltage), Vd (drain voltage), and Id (drain current) with equations including variables such as the channel length L, the channel width W, and so on of the gate, and a plurality of parameters, and a large number of models have been proposed. In the above simulations, for example, a typical and well-known BSIM (Berkeley Short Channel IGFET Model) has been used.

The BSIM is formed of a large number of equations, and the number of parameters to be adjusted is from several tens to more than several hundreds. Incidentally, because details of the physical models of transistors and conventional parameter adjusting methods are described, for example, in the following document, their detailed explanations are omitted.

Non-patent document 1: Toru Toyabe, ed., "MOSFET Modeling and BSIM3 Users Guide", February 28, 2002, published by Maruzen

In the following Patent Document 1 previously filed by the present inventors, a parameter adjusting device which automatically performs adjusting processing of a plurality of parameters of the physical models of the transistors using genetic algorithms has been proposed.

Patent document 1: Japanese Patent Publication (TOKKAI) No. 2005-038216

DISCLOSURE OF THE INVENTION

PROBLEMS TO BE RESOLVED BY THE INVENTION

In the above-mentioned conventional parameter adjusting method, an initial individual population or child individuals generated parameters randomly within a predetermined range. In the case that there are a large number of initial individuals or child individuals to be generated, even if the parameters were generated randomly, distribution of the parameters becomes nearly uniform, and does not become disproportionate. However, in a high-dimensional applicable field wherein the number of parameters becomes between several tens and several hundreds such as the physical model of the transistor, when the number of individuals increases, a large amount of time is required until required accuracy is reached, so that evaluation cannot be performed.

The number of populations being realistically able to perform the evaluation by a current computer is, for example, approximately between a few hundreds and a few thousands. When the parameters of individuals of the above-mentioned range of amount were randomly generated within a predetermined range, distribution of the parameters became disproportionate, and even if the evaluation of a genetic algorithm was repeated, accuracy (evaluated value of the individuals) was hard to be improved.

The present invention is made in order to solve the above-mentioned problems, and provides a parameter adjusting device being able to adjust a large number of parameters in a physical model of a semiconductor element such as a transistor and so on within a short time.

MEANS OF SOLVING THE PROBLEMS

A parameter adjusting device of the invention is mainly characterized in that it defines a chromosome wherein a respective plurality of parameters are genes, and includes a parameter adjusting means which optimizes the parameters by using a genetic algorithm wherein a hyper uniform distribution method is adopted. Also, in the above-mentioned parameter adjusting device, the parameter adjusting means is characterized in that it adopts a Latin hyper square method as the hyper uniform distribution method. Also, in the parameter adjusting device, the parameter adjusting means is characterized in that it includes an initial population generating means of the genetic algorithm which adopts the hyper uniform distribution method.

Also, in the above-mentioned parameter adjusting device, the parameter adjusting means is characterized in that it includes a crossover process means of the genetic algorithm adopting the hyper uniform distribution method. Also, in the parameter adjusting device, the crossover process means is characterized in that it includes a generating range determination means obtaining the center of gravity in a vector space of a parent chromosome group, in crossover processing of the genetic algorithm, and determining a generating range of a child chromosome group inside a hyperpolyhedron in the vector space which is determined by values of the center of gravity and the parent chromosome group; and a parameter generating means adopting the hyper uniform distribution method within the generating range, and determining the parameter value which is the gene.

Also, in the parameter adjusting device, the hyper uniform distribution method is characterized in that it divides at least one dimensional axis in a log scale at even intervals. Also, in the parameter adjusting device, the hyper uniform distribution method is characterized in that it divides at least one dimensional axis at uneven intervals. Also, in the parameter adjusting device, the parameter is a parameter of a physical model of a semiconductor element, and based on property measured data of the tested semiconductor element, an evaluated value computation means which computes the evaluated value of each individual is provided.

EFFECT OF THE INVENTION

The parameter adjusting device of the present invention with characteristics described above has an effect that it becomes possible to determine a high-accuracy parameter group within a short time by applying the genetic algorithm to parameter adjusting of a model with a large number of parameters such as the physical model of the transistor, and further using the hyper uniform distribution method such as the Latin hyper square method.

BRIEF DESCRIPTION OF THE DRAWING

Fig. 1 is a flowchart showing all the procedures in the case wherein simulation is performed using a parameter adjusting device of the present invention.
Fig. 2 is an explanatory drawing showing a shape selection method of a transistor being tested.
Fig. 3 is a schematic flowchart showing the parameter adjusting (fitting) processing using a genetic algorithm.
Fig. 4 is a flowchart showing the contents of an initial population generating processing of S21.
Fig. 5 is a flowchart showing the contents of a selection crossover processing of S22.
Fig. 6 is an explanatory drawing showing a search range (generating range of child individuals) of a crossover when adjusted parameters are two of $\alpha$ and $\beta$, and the number of parent individuals randomly selected from an individual population is three.
Figs. 7(a), 7(b), 7(c) are explanatory drawings showing examples of parameter generation by a Latin hyper square method.
Fig. 8 is a flowchart showing the contents of an evaluated computation processing.
Fig. 9 is an explanatory drawing showing an example of the parameter generation of an initial parent population by a method of the present invention and a conventional random method.

EXPLANATION OF SYMBOLS

G        Center of gravity
P0-P2    Parent individuals

DETAILED DESCRIPTION OF PREFERRED EMBODIMENTS

Hereinafter, as an applied embodiment of the parameter adjusting device of the present invention, an example adjusting parameters of a physical model of a transistor will be disclosed. However, the parameter adjusting device of the present invention can be applied to the physical model of the heretofore known arbitrary semiconductor element, and other heretofore known arbitrary model such as a fluid flow model or a transmission channel model and so on.

The parameter adjusting device of the invention is realized by creating a program performing processing shown by a flowchart described hereinafter, and installing the above-mentioned program in the heretofore known arbitrary computer system which can perform the program. Incidentally, since the hardware of the computer system is heretofore known, detailed explanations are omitted. Hereinafter, an embodiment 1 will be explained.

Embodiment 1

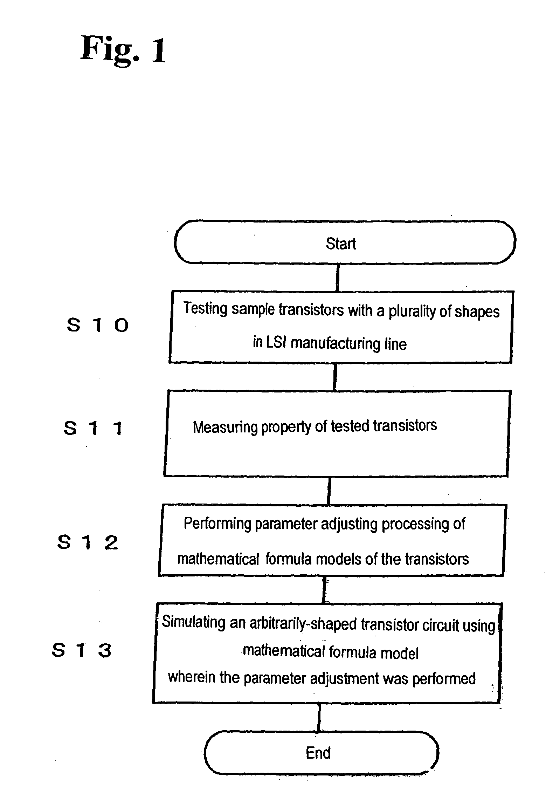

Fig. 1 is a flowchart showing all the procedures in the case wherein simulation is performed using a parameter adjusting device of the present invention. As mentioned above, in the case of LSI manufacture, first, in S10, samples of several transistors (MOSFET) with a different shape of a channel length L and channel width W and so on of a gate are tested in the LSI manufacturing line.

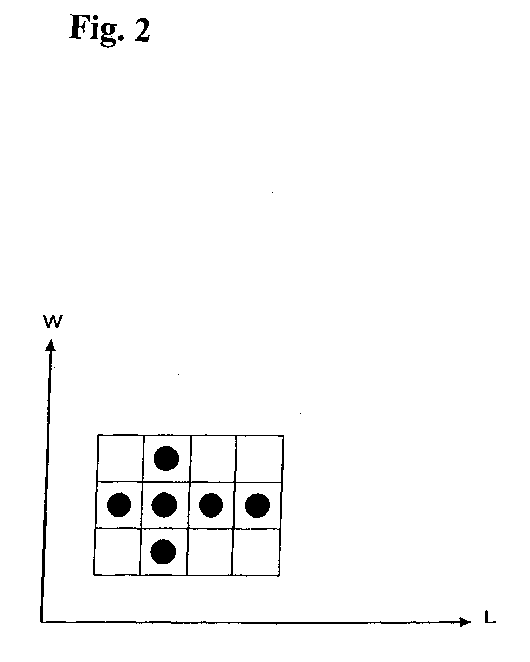

Fig. 2 is an explanatory drawing showing a shape selection method of a transistor being tested. The shape selection method divides, for example, between the maximum value and the minimum value of L and W at even intervals, or the side near the minimum value more minutely; and selects the section (shape) of the transistor being tested in such a way that the shape becomes a cruciform on an L - W plane surface.

In S11, an electric property of the tested transistor is measured. Specifically, with respect to an IdVd property (Vb fixation), IdVd property (Vg fixation), and IdVg property (Vd fixation), a respective plurality of sample values (discrete data) are measured for a plurality of times by changing fixed values. Incidentally, as other electric properties, a Gm property (transconductance), Gds property (channel conductance) may be added as the discrete data. In S12, the parameter adjusting processing of a physical model of a transistor is performed by a method described hereinafter using the parameter adjusting device of the present invention, in such a way as to match a property of the transistor which is manufactured in the relevant manufacturing line with a high degree of accuracy.

In S13, operation simulation of a transistor circuit with an arbitrary channel length and channel width which is manufactured in the relevant manufacturing line using the heretofore known circuit simulation program such as SPICE, is performed using the physical model wherein the parameters are adjusted. By using the parameter adjusting device of the invention, parameters of the physical model with a high degree of accuracy can be obtained within a short time, and simulation with a high degree of accuracy can be performed.

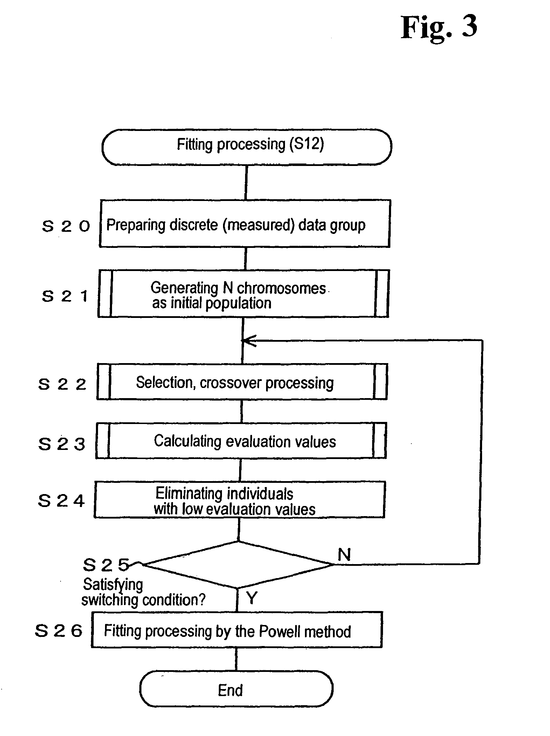

Fig. 3 is a schematic flowchart showing the parameter adjusting (fitting) processing using a genetic algorithm. In S20, one or more discrete data groups (measurement results) are prepared. In S21, N individuals (chromosomes) having arbitrary parameters of physical model functions of transistors as genes are generated as an individual initial population. Individual generation is to decide the parameter values of the genes in the chromosome wherein the individuals have.

In the BSIM, although there are a large number of parameters as previously noted, depending on the contents to be simulated, there are parameters which may be fixed to representative values without adjusting, or ignored. Accordingly, the number n of parameters to be adjusted differs according to the purpose of the simulation, and although there may be 100 or more, it also may be, for example, 10. Therefore, the parameters such as the number of chromosomes (individuals) N or the number of generated children m in the genetic algorithm are changed depending on the number of the parameters n to be adjusted. Accordingly, the processing becomes faster as the number n becomes smaller. In the embodiment, for example, the number of individuals is set to be N = n x 15.

Also, in the BSIM, because a recommended range of initial parameter values is established for each parameter, an initial value is determined within the recommended range of initial parameter values for each parameter as the value of the genes by a method as described hereinafter. Incidentally, in the case wherein the recommended range of the initial parameter values is broad, values of the genes corresponding to the parameters may be generated in a log scale.

In S22, chromosomes to become parent individuals are selected from the individual population generated in S21. The number of parent individuals p selected in the processing is less than or equal to N. Child individuals of the number m are generated from the selected parent individuals by the after-mentioned crossover processing. In S23, the evaluation values of the child individuals generated in S22 are computed (the details are described later).

In S24, the parent individuals selected in S22 and p in the order of better evaluation from the generated child individuals are returned to the individual parent population, and the rest are discarded. By this processing, the chromosomes having low evaluation values are eliminated. In addition, a method also may be adopted, in which a portion of the parent individuals is returned as-is to the parent population without being subject to elimination, and a number in the amount of "remaining parent individuals" and the remaining parent individuals in the order of better evaluation from the child individuals are returned.

In S25, it is determined whether an algorithm switching condition is satisfied. If the condition is not satisfied, it returns to S22, but if the condition is satisfied, it moves to S26. As the condition, whether the number of computations exceeds a predetermined value, or a rate of reduction of the evaluation value becomes less a predetermined value can be used. In S26, adjustment of the parameters is performed by, for example, the well-known Powell method as a local search method or other well-known local search method. By switching the search method in this manner, the time of parameter adjustment is shortened.

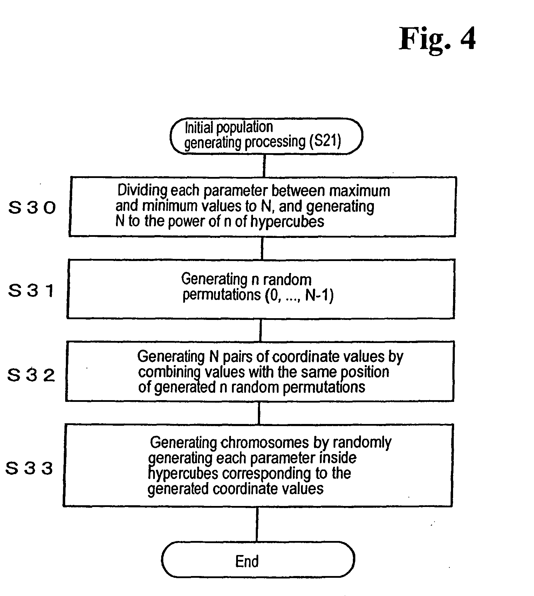

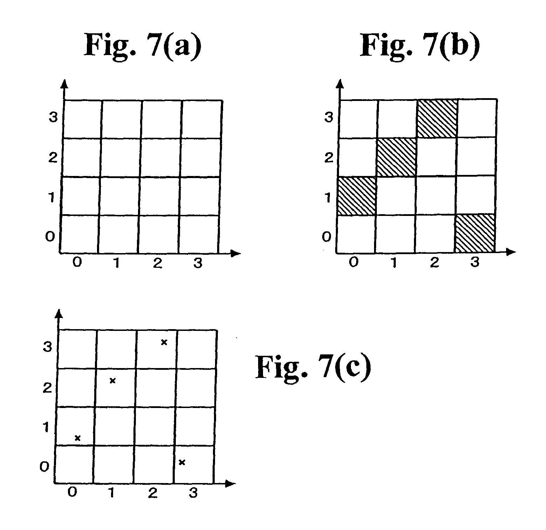

Fig. 4 is a flowchart showing the contents of an initial population generating processing of S21. Conventionally, in the generation of the initial individual population, although the parameters were randomly generated within a predetermined range, in this embodiment, a Latin hyper square method (also called a Latin hypercube sampling, Latin hypercube method, or Latin superlattice method) which is a type of hyper uniform distribution is adopted for the generation of the initial individual population. Figs. 7(a), 7(b), 7(c) are explanatory drawings showing examples of parameter generation by the Latin hyper square method. Since the Latin hyper square method itself is well-known, the general description will be explained.

In S30 in Fig. 4, respective parameters of the number n are divided into N between the maximum values and minimum values, and N to the power of n of hypercubes is generated. In order to simplify the explanation of Figs. 7(a), 7(b), 7(c), an example equally dividing the number of parameters n = 2 by the number of partitions N = 4, is shown. In Fig. 7(a), 16 squares (if they are three-dimensional, they will become cubes, and if they are four-dimensional or more than four-dimensional, they will become hypercubes) are generated. Incidentally, in the parameters which are predictable beforehand such as, for example, the parameters whose optimum value stands a good chance of being near the middle of the maximum values and minimum values, the axis of the dimension may be unequally divided in such a way that, for example, measure to be divided is broken up in the middle portion.

In S31, random permutations (0, ..., N-1) of the number n are generated. These random permutations are performed wherein integer numbers from 0 to N-1 are randomly lined, and although a large number of permutation patterns are possible, among those patterns, an arbitrary pattern of the number n of the random permutations is generated. Incidentally, in the general Latin hyper square method, the same pattern of the random permutations is eliminated. However, in this invention, the same pattern of the random permutations is allowed. In the case of the examples in Figs. 7(a), 7(b), 7(c), for example, a permutation (1, 3, 2, 0) or (2, 0, 3, 1) and so on is possible.

In S32, N pairs of coordinate values are generated by combining values with the same position of the generated n random permutations. More specifically, according to the above-mentioned examples, by combining the values with the same position of two random permutations (1, 3, 2, 0) and (2, 0, 3, 1), N = 4 pairs (1, 2) (3, 0) (2, 3) (0, 1) of hypercube (square) coordinate values can be generated. In Fig. 7(b), squares corresponding to the generated hypercube coordinate values are shown by hatched lines.

In S33, inside the hypercube corresponding to the generated coordinate values, the individual (chromosome) is generated by randomly generating each parameter. In Fig. 7(c), genes (parameters) of the generated individual are shown by x marks. Incidentally, each parameter generated inside the hypercube may be a median value of a divided section.

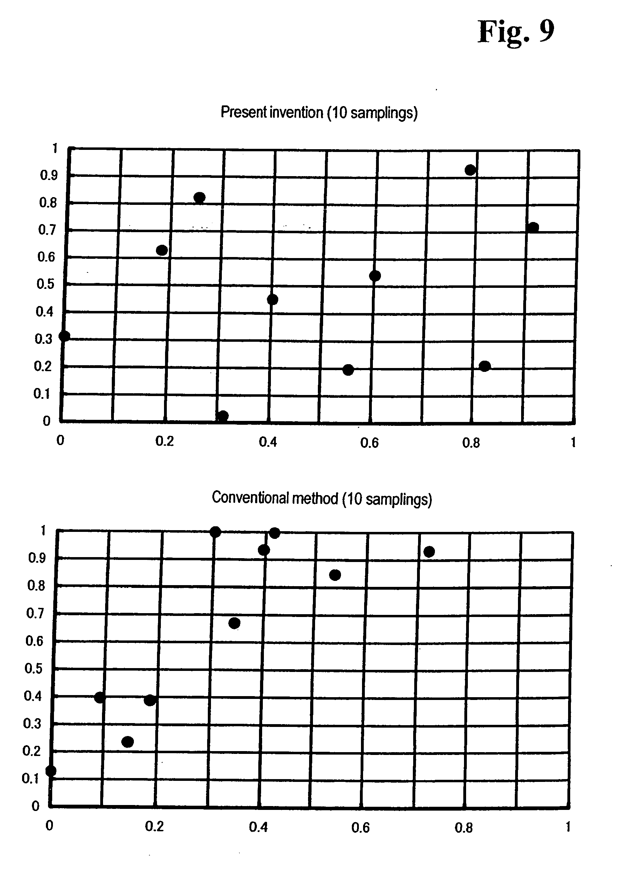

Fig. 9 is an explanatory drawing showing an example of the parameter generation of an initial parent population by a method of the invention and a conventional random method. The lower part of Fig. 9 shows the example of the parameter generation which adopted the conventional random method. In the case of a small number of populations, when the parameters are randomly generated within an area, as shown in the figure, a disproportionate condition may be generated. The upper part of Fig. 9 shows the example of the parameter generation which adopted the Latin hyper square method of the invention. This is the example of being divided equally by the number of parameters n = 2, the number of partitions N = 10. As shown in the figure, the parameters can be found to be distributed equally within a two-dimensional area.

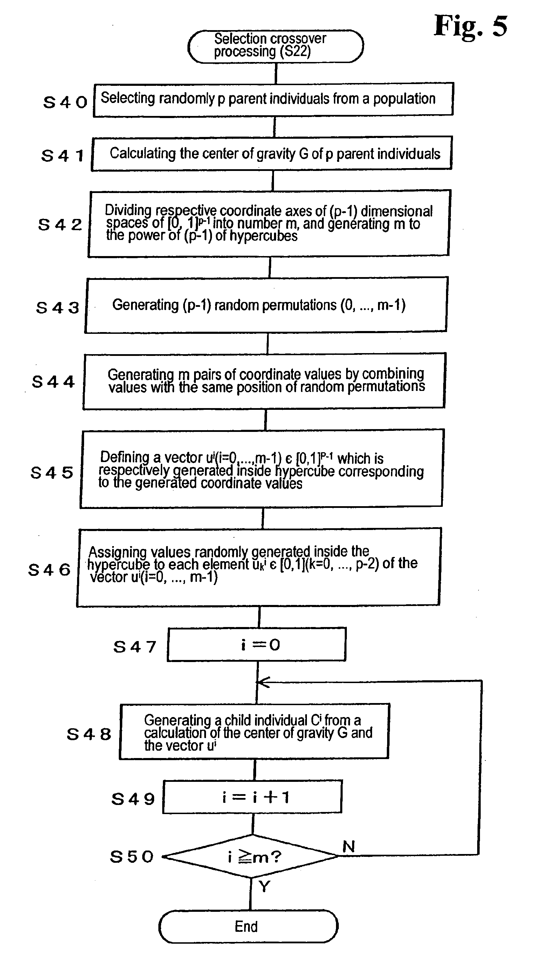

Next, a crossover processing in the present invention will be explained. Fig. 5 is a flow chart showing the contents of the selection crossover processing in S22. This crossover method is oriented toward values of real numbers, which generates genes of child individuals among a polyhedron computed from genes of a plurality of parent individuals, and the Latin hyper square method is used.

In S40, p parent individuals are randomly selected from the individual population. The value of p is desirably defined as p = n + 1 when there are n parameters to be adjusted. In S41, the center of gravity G of the p parent individuals selected in S40 is computed. That is, an average value is sought for each parameter.

In S42, in (p-1) dimensional spaces whose domain are respectively [0, 1], respective coordinate axes are divided into the number m, and m to the power of (p-1) of hypercubes are generated. In S43, the number (p-1) of random permutations (0, ..., m-1) are generated. In S44, m pairs of the coordinate values are generated by combining values with the same position of the random permutations.

In S45, a vector $u^i (i=0, ..., m-1) \in [0,1]^{P-1}$ which is respectively generated inside the hypercube corresponding to the generated coordinate values is defined. In S46, the values randomly generated inside the hypercube is assigned to each element $u_k^i \in [0,1] (k=0, ..., p-2)$ of the vector $u^i (i=0, ..., m-1)$.

In S47, the value of a variable i is set 0, and in S48, a child individual $C^i$ is generated by the following numeral formula from the center of gravity G and the vector $u^i$ which is distributed super-equally.

[Numeral 1]

$$C^i = x_{p-1} + C^i_{p-1}$$

$$x_k = G + \varepsilon(P_k - G)$$

$$C^i_k = \begin{cases} 0 & (k = 0) \\ r^i_{k-1}(x_{k-1} - x_k + C^i_{k-1}) & (k=1, \ldots, p-1) \end{cases}$$

$$r^i_k = (u^i_k)^{\frac{1}{k+1}}$$

Here, the reference alphabet p represents the number of the selected parent individuals, the reference alphabet $C^i$ represents a vector showing the chromosomes of the child individuals which will be generated, and the reference alphabet $P_k$ represents a vector showing the chromosomes of the selected parent individuals. The reference alphabet $x_k$ is computed from the vector of each parent individual, and represents a vector which determines a generating range of the genes of the child individual. The reference alphabet $C_k^i$ represents a vector which is generated in sequence by overlapping vector components based on the above-mentioned $u_k^i$ and $x_k$. Incidentally, regarding the parameters wherein the initial value of the genes was generated in the log scale, the computation is performed in the log scale even in the case of generating the child individual.

In S49, 1 is added to the variable i, and in S50, whether or not the variable i is larger than m is determined. If a determined result is negative, the parameters return to the S48, and if the result is positive, the processing is completed. Due to the processing, the child individuals of the number m are generated. The number m is desirable to be approximately 10 x n.

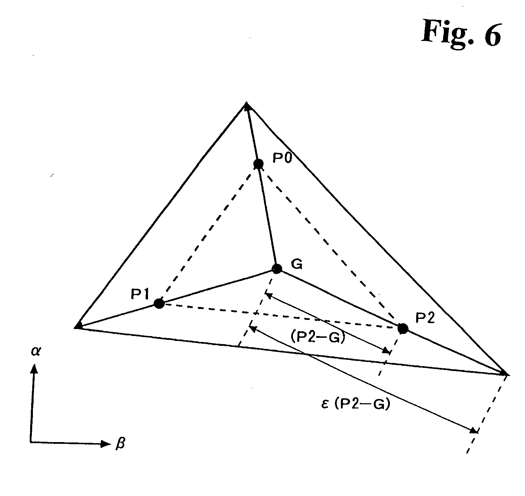

Fig. 6 is an explanatory drawing showing a search range (generating range of the child individuals) of a crossover when adjusted parameters are two of $\alpha$ and $\beta$, and the number of the parent individuals randomly selected from the individual population is three. A vector from the center of gravity G to each parent individual P1~P3 is increased $\varepsilon$ times, the generating range (inside of an outside triangle in Fig. 6) of the child individual is determined, and by using the Latin hyper square method, the child individuals are generated from the range. When the number of the parent individuals is p, the recommended value of $\varepsilon$ is $\sqrt{(p+1)}$. Incidentally, when the number of the parameters is three or more, the generating range of the child individuals is an internal space of a hyperpolyhedron surrounded by a plurality of hyperplanes.

Next, the computation of the evaluated value computed in S23 will be explained. The evaluated value of the chromosomes is computed based on a prepared discrete data group and an estimated data group which is computed by a transistor electric property model function wherein the genes of the chromosomes are the model parameters. The evaluated value is a value showing how close to an ideal value with the genes of the chromosomes as a model parameter.

There is a portion showing a substantial change of values in the discrete data group, when the figure is viewed with the log scale, although the values look like approximately 0 when the figure is viewed with a linear scale. The above-mentioned quality is called a sub-threshold property. Since the absolute value of the above-mentioned portion is small compared to the other part, the absolute value of an error is also small, so that it is difficult to optimize this portion by using only a data group of a usual linear scale.

Also, in order to adjust this portion, if only a data group of the log scale is prepared and optimized, the sub-threshold property can be optimized; however, an error in the other part except for the above-mentioned portion becomes large, and a gap is developed.

In the invention, in view of the circumstances in an MOS transistor electric property model parameter wherein parameters which estimate a subthreshold property and parameters which estimate the other part except for the above-mentioned portion are independent from each other, a data group of the log scale and a data group of the linear scale are read simultaneously by the following scaling processing, and all the properties are adjusted simultaneously.

Incidentally, in the case wherein the scaling differs between the discrete data groups, if error of mean square is taken, an effect on the evaluated value becomes small in the data group with a small scale. Therefore, the accuracy of the adjustment may be deteriorated even if the above-mentioned scaling processing is performed. Consequently, in the present invention, the discrete data among each data group is normalized, and the adjustment accuracy can be improved by unifying the scale.

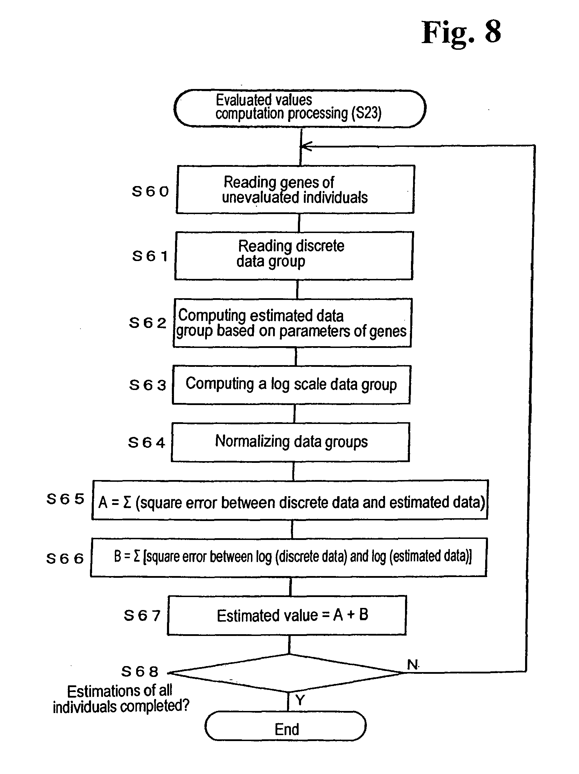

Fig. 8 is a flowchart showing the contents of an evaluated computation processing. In S60, gene information of the unvalued individuals is read, and becomes the model parameter of the transistor electric property model function. In S61, a discrete data group is read. In S62, an estimated data group which estimates a discrete data group is calculated based on the parameter of the genes.

In S63, logarithm data wherein a discrete data group and an estimated data group corresponding to the discrete data group are converted into a log scale, is generated. Incidentally, in general, Id-Vd properties are estimated by only linear, and Id-Vg properties are estimated by both log and linear. Also, as the other electric properties, the Gm property (transconductance), Gds property (channel conductance) may be added as the discrete data. In this case, generally, the Gm property is estimated by the only linear scale, and the Gds property is estimated by the only log scale. As a matter of course, both properties may be estimated by both log and linear scales. In S64, all of the data groups are normalized. More specifically, first, the maximum value fmax and minimum value fmin of the data groups are obtained. Next, all discrete data f(i) of the data groups is converted into normalization data g(i) by the following numerical formula 2.

[Numeral 2]

$$g(i) = (f(i) - f_{min}) / (f_{max} - f_{min})$$

Here, g(i) represents the normalization data; f(i) represents the discrete data; fmax represents the maximum value of the data groups; and fmin represents the minimum value of the data groups. Due to the above-mentioned calculation, the discrete data can be normalized within the range of [0, 1].

In S65, evaluated value A = E (square error between normalization discrete data and normalization estimated data) of only the data group of the linear scale is computed. In S66, the evaluated value B = Σ [square error between log (normalization discrete data) and log (normalization estimated data)] of only the data group of the log scale is computed.

In S67, A + B is the estimated value. Incidentally, although the square error is used for calculating the estimated value, an error rate may be obtained instead of the square error. In S68, whether or not evaluated values of all the individuals are completed is determined. If a determined result is negative, the parameters move into the S60, and if the result is positive, the processing is completed.

By the above-mentioned processing, high-accuracy parameter adjustment can be performed within a short time. By adopting the relevant parameters to the physical model, a high-accuracy circuit simulation can be performed without a test, so that efficiency in manufacturing a semiconductor element improves.

Embodiment 1 is explained in the above; however, the following transformational example can be used as the parameter adjusting device of the present invention. In the embodiment, although the Latin hyper square method is cited as an example of the hyper uniform distribution, other hyper uniform distribution such as the heretofore known LSS (Latin Supercube Sampling) and so on may be adopted as the hyper uniform distribution.

Although the BSIM is taken as an example of the physical model, in the present invention, the physical model of the heretofore known arbitrary semiconductor element besides the BSIM can be used. Also, this invention can be applicable to the parameter adjustment of the heretofore known arbitrary physical models and additionally various types of models besides the physical models.

**Claims**

1. A parameter adjusting device, comprising:

a parameter adjusting means for defining a chromosome wherein a respective plurality of parameters are genes and optimizing said parameters using a genetic algorithm which adopts a hyper uniform distribution method.

2. A parameter adjusting device according to claim 1, wherein said parameter adjusting means adopts a Latin hyper square method as the hyper uniform distribution method.

3. A parameter adjusting device according to claim 1, wherein said parameter adjusting means comprises an initial population generating means of the genetic algorithm adopting the hyper uniform distribution method.

4. A parameter adjusting device according to claim 1, wherein said parameter adjusting means comprises a crossover process means of the genetic algorithm adopting the hyper uniform distribution method.

5. A parameter adjusting device according to claim 1, wherein said crossover process means comprises:

a generating range determination means obtaining a center of gravity in a vector space of a parent chromosome group, in a crossover processing of the genetic algorithm, and determining a generating range of a child chromosome group inside a hyperpolyhedron in the vector space which is determined by values of said center of gravity and parent chromosome group; and
a parameter generating means adopting the hyper uniform distribution method within said generating range, and determining the parameter value which is the gene.

6. A parameter adjusting device according to claim 1, wherein said hyper uniform distribution method evenly divides at least one dimensional axis in a log scale.

7. A parameter adjusting device according to claim 1, wherein said hyper uniform distribution method unevenly divides at least one dimensional axis.

8. A parameter adjusting device according to claim 1, wherein said parameter is a parameter of a physical model of a semiconductor element, and an evaluated value computation means which computes an evaluated value of each individual based on property measured data of tested semiconductor element is provided.

# Fig. 1

```
                    ┌─────────────────────────────────┐
                    │             Start               │
                    └─────────────────────────────────┘
                                    │
S 1 O       ┌───────────────────────────────────────────┐
            │ Testing sample transistors with a plurality of shapes │
            │            in LSI manufacturing line            │
            └───────────────────────────────────────────┘
                                    │
S 1 1       ┌───────────────────────────────────────────┐
            │      Measuring property of tested transistors      │
            └───────────────────────────────────────────┘
                                    │
S 1 2       ┌───────────────────────────────────────────┐
            │      Performing parameter adjusting processing of      │
            │     mathematical formula models of the transistors     │
            └───────────────────────────────────────────┘
                                    │
S 1 3       ┌───────────────────────────────────────────┐
            │ Simulating an arbitrarily-shaped transistor circuit using │
            │             mathematical formula model             │
            │    wherein the parameter adjustment was performed    │
            └───────────────────────────────────────────┘
                                    │
                    ┌─────────────────────────────────┐
                    │             End                 │
                    └─────────────────────────────────┘
```

# Fig. 2

# Fig. 3

```
        ┌──────────────────────────────────┐
        │     Fitting processing (S12)      │
        └──────────────────────────────────┘
                        │
   ┌──────┐  ┌──────────────────────────────────┐
   │ S 2 O │  │ Preparing discrete (measured) data group │
   └──────┘  └──────────────────────────────────┘
                        │
   ┌──────┐  ┌──────────────────────────────────┐
   │ S 2 1 │  │ Generating N chromosomes          │
   └──────┘  │ as initial population             │
             └──────────────────────────────────┘
                        │
   ┌──────┐  ┌──────────────────────────────────┐
   │ S 2 2 │  │ Selection, crossover processing   │
   └──────┘  └──────────────────────────────────┘
                        │
   ┌──────┐  ┌──────────────────────────────────┐
   │ S 2 3 │  │ Calculating evaluation values     │
   └──────┘  └──────────────────────────────────┘
                        │
   ┌──────┐  ┌──────────────────────────────────┐
   │ S 2 4 │  │ Eliminating individuals           │
   └──────┘  │ with low evaluation values        │
             └──────────────────────────────────┘
                        │
   ┌──────┐         ◇ Satisfying            N
   │ S 2 5 │        switching condition?
   └──────┘              │ Y
   ┌──────┐  ┌──────────────────────────────────┐
   │ S 2 6 │  │ Fitting processing by the Powell method │
   └──────┘  └──────────────────────────────────┘
                        │
        ┌──────────────────────────────────┐
        │               End                 │
        └──────────────────────────────────┘
```

# Fig. 4

```
        ┌─────────────────────────────────┐
        │ Initial population              │
        │ generating processing (S21)     │
        └─────────────────────────────────┘
                        │
┌──────────┐ ┌─────────────────────────────────────────┐
│   S 3 0  │ │ Dividing each parameter between maximum  │
│          │ │ and minimum values to N, and generating  │
│          │ │ N to the power of n of hypercubes        │
└──────────┘ └─────────────────────────────────────────┘
                        │
┌──────────┐ ┌─────────────────────────────────────────┐
│   S 3 1  │ │ Generating n random                      │
│          │ │ permutations (0, ..., N-1)               │
└──────────┘ └─────────────────────────────────────────┘
                        │
┌──────────┐ ┌─────────────────────────────────────────┐
│   S 3 2  │ │ Generating N pairs of coordinate values  │
│          │ │ by combining values with the same        │
│          │ │ position of generated n random           │
│          │ │ permutations                             │
└──────────┘ └─────────────────────────────────────────┘
                        │
┌──────────┐ ┌─────────────────────────────────────────┐
│   S 3 3  │ │ Generating chromosomes by randomly       │
│          │ │ generating each parameter inside         │
│          │ │ hypercubes corresponding to the          │
│          │ │ generated coordinate values              │
└──────────┘ └─────────────────────────────────────────┘
                        │
            ┌─────────────────────────────┐
            │            End              │
            └─────────────────────────────┘
```

**Fig. 5**

```
         ( Selection crossover )
         (   processing (S22)  )
                   |
S40 | Selecting randomly p parent individuals from a population |
                   |
S41 | Calculating the center of gravity G of p parent individuals |
                   |
S42 | Dividing respective coordinate axes of (p-1) dimensional
      spaces of [0, 1]^{P-1} into number m, and generating m to
      the power of (p-1) of hypercubes |
                   |
S43 | Generating (p-1) random permutations (0, ..., m-1) |
                   |
S44 | Generating m pairs of coordinate values by combining
      values with the same position of random permutations |
                   |
S45 | Defining a vector u^i(i=0,...,m-1) ∈ [0,1]^{P-1} which is
      respectively generated inside hypercube corresponding
      to the generated coordinate values |
                   |
S46 | Assigning values randomly generated inside the
      hypercube to each element u_k^i ∈ [0,1](k=0, ..., p-2) of the
      vector u^i(i=0, ..., m-1) |
                   |
S47 |          i = 0          |
                   |
S48 | Generating a child individual C^i from a
      calculation of the center of gravity G and
      the vector u^i |
                   |
S49 |        i = i + 1        |
                   |
S50 <      i ≥ m?      > N
          |
          Y
          |
        ( End )
```

**Fig. 6**

Fig. 7(a)

Fig. 7(b)

Fig. 7(c)

# Fig. 8

Evaluated values
computation processing (S23)

S60 — Reading genes of
unevaluated individuals

S61 — Reading discrete
data group

S62 — Computing estimated data
group based on parameters of genes

S63 — Computing a log scale data group

S64 — Normalizing data groups

S65 — $A = \Sigma$ (square error between discrete data and estimated data)

S66 — $B = \Sigma$ [square error between log (discrete data) and log (estimated data)]

S67 — Estimated value = A + B

S68 — Estimations of all
individuals completed?

N

Y

End

16

# Fig. 9

Present invention (10 samplings)

Conventional method (10 samplings)

<div align="center">

**INTERNATIONAL SEARCH REPORT**

</div>

| International application No. |
|---|
| PCT/JP2006/307053 |

| A. CLASSIFICATION OF SUBJECT MATTER |
|---|
| *G06N3/00*(2006.01), *G06F17/50*(2006.01) |

According to International Patent Classification (IPC) or to both national classification and IPC

| B. FIELDS SEARCHED |
|---|

Minimum documentation searched (classification system followed by classification symbols)
*G06N3/00*(2006.01), *G06F17/50*(2006.01)

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X | Ronald W. Morrison, Dispersion-based Population Initialization, Genetic and Evolutionary Computation Conference, USA, 12 July, 2003 (12. 07.03), Proceedings, pages 1210 to 1221 | 1,2 |

☐ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 June, 2006 (20.06.06) | 27 June, 2006 (27.06.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/307053

---

**Box No. II**     **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III**     **Observations where unity of invention is lacking (Continuation of item 3 of first sheet)**

This International Searching Authority found multiple inventions in this international application, as follows:
    The technical matter common to the inventions of claims 1-8 is to "comprise parameter adjusting means for optimizing the parameters by using a genetic algorithm adopting the hyperuniform distribution method". However, the international search has revealed that the parameter adjusting means is not novel since it is disclosed in prior art document. Consequently, since the parameter adjusting means makes no contribution over the prior art, the common mater (parameter adjusting means) is not a special technical feature... Therefore, there is no matter common to all the inventions of claims 1-8.
    Since there is no other common matter considered as a special technical feature within the meaning of PCT Rule 13.2,  (Continued to extra sheet.)

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:  1-2

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (April 2005)

**INTERNATIONAL SEARCH REPORT**

International application No.

PCT/JP2006/307053

Continuation of Box No.III of continuation of first sheet(2)

second sentence, no technical relationship within the meaning of PCT Rule 13 between the different inventions can be seen. Consequently, the inventions of claims 1-8 obviously do not satisfy the requirement of unity of invention.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005038216 A

**Non-patent literature cited in the description**

- MOSFET Modeling and BSIM3 Users Guide. Maruzen, 28 February 2002